(19) Europäisches Patentamt
European Patent Office
Office européen des brevets

(11) Veröffentlichungsnummer: **0 311 825**
**A1**

## (12) EUROPÄISCHE PATENTANMELDUNG

(21) Anmeldenummer: 88115693.9

(22) Anmeldetag: 23.09.88

(51) Int. Cl.⁴: **H02H 3/44** , **G01R 23/12**

(30) Priorität: 16.10.87 CH 4076/87

(43) Veröffentlichungstag der Anmeldung:
**19.04.89 Patentblatt 89/16**

(84) Benannte Vertragsstaaten:
**CH DE FR GB LI**

(71) Anmelder: **BBC Brown Boveri AG**
**Hàselstrasse**
**CH-5401 Baden(CH)**

(72) Erfinder: **Fromm, Wilhelm, Dr.**
**Breitensteinstrasse 40**
**CH-5417 Untersiggenthal(CH)**

(54) **Frequenzrelais.**

(57) Es wird ein Frequenzrelais beschrieben zur Ueberwachung der Frequenz eines periodischen Signals bezüglich Abweichung von einer Nennfrequenz, bei welchem das Signal abgetastet wird und die Abtastwerte mit einem Mikroprozessor ausgewertet werden. Aus mindestens jeweils drei Abtastwerten werden mittels digitaler Filter Imaginärteil und Realteil von komplexen Zeigern des periodischen Signals zu zwei verschiedenen Zeitpunkten ermittelt und daraus eine der Phasendifferenz des periodischen Signals zu diesem Zeitpunkt entsprechenden Grösse ermittelt. Diese wird einer Grenzwertüberwachung unterzogen.

EP 0 311 825 A1

## Frequenzrelais

### Technisches Gebiet

Die vorliegende Erfindung betrifft ein Frequenzrelais. Sie betrifft insbesondere ein Frequenzrelais zur Ueberwachung der Frequenz eines periodischen, wenigstens annähernd sinusförmigen Signals bezüglich Abweichung von einer Nennfrequenz, bei welchem das Signal abgetastet wird und die Abtastwerte mit einem Mikroprozessor ausgewertet werden.

In vielen technischen Systemen wird mit periodischen Signalen gearbeitet. In der elektrischen Energietechnik sind diese Signale annähernd sinusförmig und weichen im allgemeinen nur wenig von einer festen Nennfrequenz ab. Die genaue Frequenz dieser Signale muss von verschiedenen Mess-, Steuer-, Regel- und Schutzeinrichtungen gemessen werden.

Frequenzrelais stellen einen typischen Vertreter von frequenzmessenden Einrichtungen bzw. Geräten dar. Sie müssen einen Auslösebefehl liefern, wenn die aktuelle Frequenz einen bestimmten Grenzwert erreicht hat. Beispielsweise muss ein Generator dann vom Netz getrennt werden, wenn die aktuelle Netzfrequenz zu stark von der Generator-Nennfrequenz abweicht.

### Stand der Technik

Ein Frequenzrelais der eingangs genannten Art ist aus der DE-B-21 55 470 bekannt. Bei dem bekannten Frequenzrelais wird die Frequenz aus dem Abstand der Nulldurchgänge des periodischen Signals bestimmt. Die Lage der Nulldurchgänge wird durch eine rechnerisch aufwendige Interpolation zwischen Abtastwerten er mittelt. Die Genauigkeit der Frequenzbestimmung hängt entscheidend von der Abtastrate ab. Nur bei einer hohen Abtastrate wird eine hinreichende Genauigkeit erreicht.

In M.S. Sachdev., M.M. Giray: A least error squares technique for determining power system frequency, IEEE Transactions on Power Apparatus and Systems, Vol. PAS-104, No 2, Feb. 1985, S. 437-443 ist ein Frequenzmessverfahren beschrieben, das ebenfalls mit Abtastwerten arbeitet, das jedoch auf eine Anpassung der Frequenz mit Hilfe der Methode der kleinsten quadratischen Fehler beruht. Der benötigte Rechenaufwand ist erheblich.

### Darstellung der Erfindung

Es ist Aufgabe der vorliegenden Erfindung, ein Frequenzrelais der eingangs genannten Art anzugeben, welches in einfacher Weise realisierbar und selbst bei geringer Abtastrate noch genügend genau ist. Weiter soll kein grosser Rechenaufwand erforderlich sein. Die genannten sowie weitere Aufgaben werden gemäss der vorliegenden Erfindung gelöst durch die Angabe eines Frequenzrelais mit den Merkmalen des Anspruchs 1.

Anstelle der Auswertung von Abständen der Nulldurchgänge des Signals oder der Ausführung von Fehlerrechnung lehrt die vorliegende Erfindung eine direkte Frequenzmessung aus Abtastwerten des Signals und zwar über die Phasendifferenz des zu messenden Signals zwischen zwei Zeitpunkten.

Da nach der Erfindung lediglich Phasenunterschiede zwischen zwei Zeitpunkten des Signals ausgewertet werden, ist die Messung in weiten Grenzen unabhängig von der Signalamplitude. Auch spielt die absolute Phase des Signals keine Rolle.

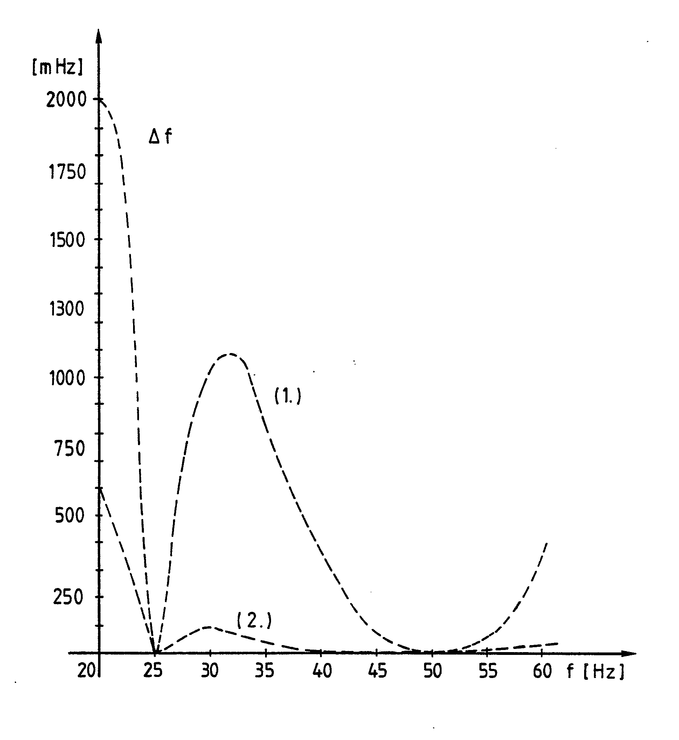

### Kurze Beschreibung der Zeichnung

Weitere Vorteile und vorteilhafte Ausgestaltungen der vorliegenden Erfindung ergeben sich aus der nachstehenden Beschreibung, insbesondere unter Berücksichtigung der beigefügten Zeichnung. In der Zeichnung ist in einem einzigen Diagramm der sich bei der Erfindung ergebende Fehler der Frequenzbestimmung als Funktion der Frequenz aufgetragen.


## Weg zur Ausführung der Erfindung

Der Erfindung liegen die folgenden Ueberlegungen zugrunde:

Betrachtet werden zwei Zeitpunkte t2 und t1 und die Phasen P(t2) und P(t1) des periodischen Signals zu diesen Zeitpunkten.

Bei einer bestimmten Frequenz, z.B. der Nennfrequenz fN des Signals, besteht eine feste Phasendifferenz $\delta P0$ zwischen den beiden Zeitpunkten t2 und t1:

$$\delta P0 = P(t2) - P(t1) \text{ bei } f = fN \qquad (1)$$

Weicht die Frequenz vom Nennwert ab, ändert sich die Phasendifferenz linear mit dem Wert der Frequenzabweichung:

$$\delta P = \delta P0 + k\,(f - fN) \qquad (2)$$

Daraus erhält man die Frequenz zu

$$f = fN + (\delta P - \delta P0)\,/\,k \qquad (3)$$

k ist hier ein Skalierungsfaktor. Nach Bestimmung der Phasendifferenz des betrachteten Signals zwischen Zeitpunkten t2 und t1 lässt sich die gesuchte Frequenz mit Gleichung (3) direkt berechnen.

Andererseits kann durch Ueberwachung der Phasendifferenz $\delta P$ auf Ueberschreitung eines oberen Grenzwertes und/oder Unterschreitung eines unteren Grenzwertes die Frequenz des periodischen Signals auf Abweichung von der Nennfrequenz fN um einen kritischen Betrag überwacht werden, um bei Grenzwertüber- bzw. unterschreitung eine Schutzfunktion auslösen zu können.

Es gilt also, die Phasendifferenz SP des Signals zwischen zwei Zeitpunkten t1 und t2 zu bestimmen.

Bekanntlich lassen sich sinusförmige Signale S(t) durch komplexe Zeiger darstellen. Im folgenden seien mit

$$\underline{S1} = Re\,(\underline{S1}) + j Im\,(\underline{S1}) = |\underline{S1}|\,e^{jP(t1)} \qquad (4)$$

und

$$\underline{S2} = Re\,(\underline{S2}) + j IM\,(\underline{S2}) = |\underline{S2}|\,e^{jP(t2)} \qquad (5)$$

komplexe Zeiger des Signals S(t) mit Realteilen Re(S1) bzw. Re(S2), Imaginärteilen Im(S1) bzw. Im(S2) und Phasen P(t1) bzw. P(t2) bezeichnet. Die Phase P(t1) des Zeigers S1 soll der Phase des Signals S(t) zu einem Zeitpunkt t1 und die Phase P(t2) des Zeigers S2 der Phase des Signals S(t) zu einem Zeitpunkt t2 entsprechen.

Aus den Gleichungen (4) und (5) ergibt sich für die Phasen:

$$\tan P(t1) = \frac{Im(\underline{S1})}{Re(\underline{S1})} \quad , \quad \tan P(t2) = \frac{Im(\underline{S2})}{Re(\underline{S2})} \qquad (6)$$

und

$$P(t1) = \arctan \frac{Im(\underline{S1})}{Re(\underline{S1})} \quad , \quad P(t2) = \arctan \frac{Im(\underline{S2})}{Re(\underline{S2})} \qquad (7)$$

Zur Berechnung der Phasen P(t1) und P(t2) nach den Gleichungen (7) müssen Realteil und Imaginärteil des Zeigers S1 zu einem Zeitpunkt t1 und entsprechend Realteil und Imaginärteil des Zeigers S2 zu einem Zeitpunkt t2 bekannt sein. Diese lassen sich, wie noch erläutert wird, mittels digitaler Orthogonalfilter aus Abtastwerten des periodischen Signals bestimmen.

Statt über die Berechnung der Phasenwerte P(t2) und P(t1) selbst, lässt sich die allein interessierende Phasendifferenz SP auf folgende Weise auch direkter ermitteln:

Man betrachtet einen komplexen Zeiger Q, der sich durch komplexe Multiplikation aus dem oben bereits eingeführten komplexen Zeiger S2 und dem konjugiert Komplexen des oben ebenfalls bereits eingeführten Zeigers S1 ergibt:

$$\underline{Q} = \underline{S2}\,\underline{S1}^* \qquad (8)$$

$$= |\underline{S2}|\,|\underline{S1}| \cdot e^{j[P(t2) - P(t1)]} \qquad (9)$$

Wie man sieht, ist die Phase von $\underline{Q}$ gerade die gewünschte Phasendifferenz $\delta P$. Analog den Gleichungen (6) und (7) gilt:

$$\tan [P(t2) - P(t1)] = \tan \delta P = \frac{Im(\underline{Q})}{Re(\underline{Q})} \qquad (10)$$

und

$$[P(t2) - P(t1)] = \delta P = \arctan \frac{Im(Q)}{Re(Q)} \qquad (11)$$

Realteil und Imaginärteil von Q ergeben sich aus:

$Re(\underline{Q}) = Re(\underline{S2}) Re(\underline{S1}) + Im(\underline{S2}) Im(\underline{S1})$ (12)

und

$Im(\underline{Q}) = Re(S1) Im(S2) - Re(S2) Im(S1)$ (13)

Durch Verwendung von Gleichung (11) zur Bestimmung von $\delta P$ braucht die Arcustangensfunktion nur einmal, statt zweimal bei der zuvor beschriebenen Methode, ausgeführt zu werden.

Andererseits genügt es, wenn lediglich die Phasendifferenz $\delta P$ auf Ueberschreitung eines oberen Grenzwertes bzw. Unterschreitung eines unteren Grenzwertes zu überwachen ist, diese Frequenzwertüberwachung mit der Grösse $\tan \delta P$ vorzunehmen, da der Tangens eine monotone Funktion ist. Dies ist die für die Schutzfunktion bevorzugte, weil vom Rechenaufwand her günstigste Variante.

Wie bereits erwähnt, lassen sich der Realteil und der Imaginärteil der Zeiger S1 und S2 zu einem Zeitpunkt t1 bzw. t2 mittels digitaler Orthogonalfilter aus Abtastwerten des periodischen Signals S(t) bestimmen.

Grundsätzlich sind verschiedene digitale Orthogonalfilter anwendbar.

Das verwendete digitale Orthogonalfilterpaar muss im interessierenden Frequenzbereich neben dem um 90˙ verschobenen Phasengang auch einen möglichst gleichen Amplitudenfrequenzgang aufweisen, um die Phasenberechnung des Signals nicht zu verfälschen.

Gemäss der nachstehenden Beziehungen lassen sich die Realteile $Re(Sn)$ und $Im(Sn)$ zu einem Zeitpunkt tn aus lediglich drei Abtastwerten berechnen (n steht hier für 1 oder 2):

$Re(\underline{Sn}) = f1 S(tn)$ (14)

$Im(\underline{Sn}) = f2 [S(tn) = \delta t) - S(t + \delta t)]$ (15)

f1 und f2 sind Faktoren, die vorzugsweise untereinander über die Beziehung $f1 = 2 \cdot f2$ verknüpft sind. Der Wert von f1 ist weiter vorzugsweise gleich Eins gewählt.

Zur Ausführung der beiden Gleichungen müssen also Abtastwerte zu Zeitpunkten $(tn - \delta t)$, t und $(tn + \delta t)$ herangezogen werden. Die Zeitdifferenz $\delta t$ ist vorzugsweise zu einem Viertel der Periodenlänge T des periodischen Signals S(t) bei Nennfrequenz fN gewählt.

Für den Abstand der beiden Zeitpunkte $tn = t1$ und $tn = t2$ für die Phasenbestimmung ist eine volle Periodendauer T bei Nennfrequenz ein günstiger Wert. Dieser Wert stellt einen Kompromiss dar zwischen der mit wachsendem Zeitabstand zwischen t1 und t2 grösser werdenden Genauigkeit in der Bestimmung der Phasendifferenz und dabei sich zunehmend ergebenden Mehrdeutigkeiten in der Frequenzbestimmung. Mit der vorgenannten Bemessung gibt sich bei einer Nennfrequenz des periodischen Signals von 50Hz im Frequenzbereich zwischen 45Hz und 55 Hz jedoch Eindeutigkeit hinsichtlich der Frequenzbestimmung. Für die eingangs erwähnte Anwendung ist dieser Variationsbereich ausreichend.

Die Bemessung des Abstandes der beiden Zeitpunkte t1 und t2 entsprechend einer Pericdenlänge ist auch noch deshalb von Vorteil, weil dann bei $f = f_N$ $\delta P$ klein ist ($\delta P = 0$ bei $f = f_N$). Dadurch lässt sich, sofern erforderlich, die Arcustangensfunktion leichter ausführen, z.B. durch die Berechnung einer Reihe ($\arctan x = x - x^3/3 + ...$) eventuell nur mit dem linearen Glied.

Anstelle einer Periode des periodischen Signals kann für den zeitlichen Abstand der beiden Zeitpunkte t1 und t2 auch eine halbe Periode oder ein Vielfaches einer halben Periode verwendet werden.

In dem in der Zeichnung dargestellten Diagramm ist als Kurve 1.) der sich aus der Orthogonalisierung gemäss den Gleichungen (14) und (15) ergebende Fehler der Frequenzbestimmung als Funktion der Frequenz aufgetragen, wobei von einer Nennfrequenz des periodischen Signals von 50Hz und f1 = 1 ausgegangen wurde. Wie man sieht, beträgt der Fehler im Bereich zwischen 45Hz und 55Hz höchsten 50mHz.

Eine in diesem Frequenzbereich noch erheblich geringere Fehlerabweichung von maximal 10mHz gemäss Kurve 2.) ergibt sich bei Verwendung von jeweils fünf Abtastwerten zur Bestimmung der Real- und Imaginärteile nach den folgenden Gleichungen:

$$Re(Sn) = f3 \, [S(tn - \delta t') - S(tn = \delta t')] \quad (16) \qquad (16)$$

$$Im(\overline{Sn}) = -f4 \, S(tn - \delta t'') + f5 \, S(tn) - f4 \, S(tn + \delta t'') \qquad (17)$$

$\delta t'$ und $\delta t''$ sind wieder vorgebbare Zeitdifferenzen und f3, f4 und f5 Faktoren, für die vorzugsweise gilt f4 = - f5 + f3 . Weiter sind vorzugsweise f3 zu 0,5 und f5 zu 0,75 gewählt.

Zur Ausführung der Gleichungen (16) und (17) müssen hier Abtastwerte zu Zeitpunkten $(tn - \delta t')$, $(tn + \delta t')$, $(tn - \delta t'')$ und $(tn + \delta t'')$ herangezogen werden.

Die Zeitdifferenz $\delta t'$ wird vorzugsweise zu einem Viertel und die Zeitdifferenz $\delta t''$ zur Hälfte der Periodenlänge T des periodischen Signals bei Nennfrequenz gewählt. Diese Bemessungen liegen auch der Kurve 2.) in der Zeichnung zugrunde.

Für den Abstand der beiden Zeitpunkte t1 und t2 gilt wieder das schon Ausgeführte.

Die vorstehend beschriebenen einfach realisierbaren orthogonalen Filter ergeben systematische Fehler, die in einem weiten Frequenzbereich vernachlässigbar sind (z.B. im Bereich 40Hz...60Hz systematische Fehler < 10 mHZ).

Das Verhalten der Frequenzmessung bei dynamischen Aenderungen des Messignals ist bestimmt durch die Einschwingzeit der verwendeten Filter und des Abstandes zwischen den beiden Phasenmessungen. Bei typischen Filtern und einer vollen Periode für den Abstand zwischen den beiden Phasenmessungen ist die Messung innerhalb von ca. drei Perioden eingeschwungen und stabil.

Die Erfindung ermöglicht eine einfache und genaue Frequenzüberwachung bzw. Frequenzmessung in Systemen mit Abtastwerten. Dabei müssen nur wenige Abtastwerte pro Periode bereitgestellt werden. Zusätzliche Hardware ist nicht erforderlich. Die Auswertung der Abtastwerte ist nur mit geringem Rechenaufwand verbunden.

Das beschriebene Mess- bzw. Ueberwachungsprinzip lässt sich dadurch noch weiter verbessern, dass das periodische Signal vor der Abtastung einer analogen und/oder digitalen Oeberwellen und Gleichanteile unterdrückenden Filterung unterzogen wird.

## Ansprüche

1. Frequenzrelais zur Ueberwachung der Frequenz eines periodischen, wenigstens annähernd sinusförmigen Signals bezüglich Abweichung von einer Nennfrequenz, bei welchem das Signal abgetastet wird und die Abtastwerte mit einem Mikroprozessor ausgewertet werden, dadurch gekennzeichnet, dass
- aus mindestens drei Abtaswerten mittels digitaler Filter Imaginärteil Im(S1) und Realteil Re(S1) eines ersten komplexen Zeigers S1 des Signals S(E) zu einem ersten Zeitpunkt t1 ermittelt werden;
- in analoger Weise Imaginärteil Im(S2) und Realteil Re(S2) eines zweiten komplexen Zeigers S2 des Signals S(e) zu einem zweiten Zeitpunkt t2 ermittels werden und
- aus den ermittelten Imaginär- und Realteilen eine der Phasendifferenz $\delta P$ des Signals S(t) zwischen den Zeitpunkten t2 und t1 entsprechende Grösse gebildet und einer Grenzwertüberwachung unterzogen wird.

2. Frequenzrelais nach Anspruch 1, dadurch gekennzeichnet, dass als der Phasendifferenz $\delta P$ entsprechende Grösse der nach folgender Beziehung ermittelte Tangens der Phasendifferenz $\delta P$ gebildet und der Grenzwertüberwachung unterzogen wird:

$$\tan \delta P = \frac{Re(\underline{S1}) \; Im(\underline{S2}) - Re(\underline{S2}) \; Im(\underline{S1})}{Re(\underline{S2}) \; Re(\underline{S1}) + Im(\underline{S2}) \; Im(\underline{S1})}$$

3. Frequenzrelais nach Anspruch 1, dadurch gekennzeichnet, dass die nach folgender Beziehung ermittelte Phasendifferenz $\delta P$ direkt der Grenzwertüberwachung unterzogen wird:

$$\delta P = \arctan \frac{Re(\underline{S1}) \; Im(\underline{S2}) - Re(\underline{S2}) \; Im(\underline{S1})}{Re(\underline{S2}) \; Re(\underline{S1}) + Im(\underline{S2}) \; Im(\underline{S1})}$$

4. Frequenzrelais nach Anspruch 1, dadurch gekennzeichnet, dass die nach der folgenden Beziehung ermittelte Phasendifferenz δP direkt der Grenzwertüberwachung unterzogen wird:

$$\delta P = \arctan \frac{Im(\underline{S2})}{Re(\underline{S2})} - \arctan \frac{Im(\underline{S1})}{Re(\underline{S1})}$$

5. Frequenzrelais nach einem der Ansprüche 1 bis 4, dadurch gekennzeichnet, dass die der Phasendifferenz δP entsprechende Grösse auf Unterschreitung eines unteren und/oder Ueberschreitung eines oberen Grenzwertes überwacht wird.

6. Frequenzrelais nach einem der Ansprüche 3 oder 4, dadurch gekennzeichnet, dass der Absolutbetrag der Frequenz f des Signals aus der Phasendifferenz δP mittels folgender Bezie bestimmt wird:

f = fN + (δP - δP0)/h

wobei fN die Nennfrequenz, δP0 die Phasendifferenz zwischen den Zeitpunkten t2 und t1 bei Nennfrequenz und h einen Skalierungsfaktor bedeuten.

7. Frequenzrelais nach einem der Ansprüche 1 bis 6, dadurch gekennzeichnet, dass das zu den Zeitpunkten t=t1 bzw. t=t2 die Realteile Re(S1) bzw. Re(S2) und Imaginärteile Im(S1) bzw. Im(S2) der komplexen Zeiger S1 bzw. S2 des Signals S(t) nach folgenden Beziehungen bestimmt werden:

Re(Sn) = f1 S(tn)

Im(Sn) = f2 [S(tn) - δt) - S(tn + δt)]

wobei vorzugsweies f1 = 2t2, wobei weiter vorzugsweise f1-1, wobei δt eine vorgebbare feste Zeitdifferenz ist, wobei Sn für S1 bzw. S2 und tn für t1 bzw. t2 steht und wobei die Zeitdifferenz δt vorzugweise zu einem Viertel der Periodendauer des Signals S(t) bei Nennfrequenz gewählt ist.

8. Frequenzrelais nach einem der Ansprüche 1 bis 6, dadurch gekennzeichnet, dass zu den Zeitpunkten t=t1 bzw. t=t2 die Realteile Re(S1) bzw. Re(S2) und Imaginärteile Im(S1) bzw. Im(S2) der komplexen Zeiger (S1) bzw. (S2) des Signals S(t) nach folgenden Beziehungen bestimmt werden:

Re(Sn) = f3[S(tn = δt') - S(tn + δt')]

Im(Sn) = -f4 S(tn-δt'') + f5 S(tn) -f3 S(tn + δt'')

wobei vorzugsweise f4 = - f5 + f3 , wobei weiter vorzugsweise f3 = 0,5 und f5 = 0.75, wobei δt' und δt'' vorgebbare feste Zeitdifferenzen sind, wobei Sn für S1 bzw. S2 und tn für t1 bzw. t2 steht und wobei die Zeitdifferenz δ' vorzugsweise zu einem Viertel und die Zeitdifferenz δt'' vorzugsweise zur Hälfte der Periodendauer des Signals S(t) bei Nennfrequenz gewählt wird.

9. Frequenzrelais nach einem der Ansprüche 1 bis 8, dadurch gekennzeichnet, dass der zeitliche Abstand der Zeitpunkte t2 und t1 gerade einer Periodenlänge des Signals S(t) bei Nennfrequenz entspricht.

10. Frequenzrelais nach einem der Ansprüche 1 bis 9, dadurch gekennzeichnet, dass das periodische Signal vor der Abtastung einer analogen und/oder digitalen Oberwellen und Gleichanteile unterdrückenden Filterung unterzogen wird.

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (Int. Cl.4) |
|---|---|---|---|
| X | US-A-4 661 769 (GIRGIS) <br> * Ansprüche 1-9 * <br> --- | 1 | H 02 H 3/46 <br> G 01 R 23/12 |
| X | US-A-4 547 726 (PREMERLANI) <br> * Ansprüche 1,4,13 * <br> --- | 1,9 | |
| D,A | DE-A-2 155 470 (HITACHI) <br> * Figuren 2-5; Seite 7, Zeile 25 - Seite 12, Zeile 18 * <br> --- | 1 | |
| A | GB-A-2 027 297 (LICENTIA) <br> * Zusammenfassung; Anspruch 1 * <br> ----- | 1 | |

| | |
|---|---|
| | **RECHERCHIERTE SACHGEBIETE (Int. Cl.4)** <br><br> H 02 H <br> G 01 R |

Der vorliegende Recherchenbericht wurde für alle Patentansprüche erstellt

| Recherchenort | Abschlußdatum der Recherche | Prüfer |
|---|---|---|
| DEN HAAG | 20-12-1988 | KOLBE W.H. |

KATEGORIE DER GENANNTEN DOKUMENTE

X : von besonderer Bedeutung allein betrachtet
Y : von besonderer Bedeutung in Verbindung mit einer anderen Veröffentlichung derselben Kategorie
A : technologischer Hintergrund
O : nichtschriftliche Offenbarung
P : Zwischenliteratur

T : der Erfindung zugrunde liegende Theorien oder Grundsätze
E : älteres Patentdokument, das jedoch erst am oder nach dem Anmeldedatum veröffentlicht worden ist
D : in der Anmeldung angeführtes Dokument
L : aus andern Gründen angeführtes Dokument

& : Mitglied der gleichen Patentfamilie, übereinstimmendes Dokument

EPO FORM 1503 03.82 (P0403)